# EUROPEAN PATENT APPLICATION

(11) **EP 1 965 125 A1**
(43) Date of publication of application: **03.09.2008**
(21) Application number: 06843693.0
(22) Date of filing: 22.12.2006
(51) Int. Cl.: F21S 13/00, F24C 13/00, H02N 11/00, F21W 131/105

(54) **LIGHTING SYSTEM**

(30) Priority: 24.12.2005 JP 2005381228
(71) Applicant: Mubuchi, Toshihiko, Suitashi, Osaka 5650803 (JP)
(72) Inventor: Mubuchi, Toshihiko, Suitashi, Osaka 5650803 (JP)
(74) Representative: HOFFMANN EITLE
(86) International application number: PCT/JP2006/326319
(87) International publication number: WO 2007/074917

(57) **Abstract**

Problems to Be Solved

A large amount of energy loss occurs in a conventional device which supplies visible rays from electricity to an indoor place by using an electric light such as an incandescent light or a fluorescent light.

Means for Solving the Problems

It is an object of the present invention to realize effective use of energy and realize a device which can simultaneously supply visible light, heat, and electricity, or visible light and heat, or visible light and electricity, and this is realized in a manner that a reflector plate, which has properties of reflecting visible rays and transmitting or absorbing heat rays, and a translucent panel, which has properties of transmitting visible rays and reflecting heat rays, efficiently split combustion light generated by high-brightness catalytic combustion fueled with combustible gaseous substance such as city gas, and a thermoelectric element converts heat into electricity.

## Description

### Technical Field

The present invention relates to a device which simultaneously supplies visible light, heat, and electricity, or visible light and heat, or visible light and electricity, from catalytic combustion fueled with combustible gaseous substance such as city gas.

### Background Art

Conventionally, fluorescent lights, incandescent lights, and the like using electric energy have been used for indoor illumination. In such illumination, about 5 to 20% of the electric energy input for the illumination is converted into light energy.

Here, in most cases, the electric energy is supplied from a grid of an electric power company, and it is estimated that this electric energy at a customer's premise is about 36.6% of the energy input at a power plant of the electric power company since a heat loss at the power plant and a power transmission loss is deducted from the input energy (according to a subsidy application manual for the Energy Saving Law prepared by NEDO).

This means that 1.9 to 7.3% of the energy originally input at the power plant is supplied as light and most of the 92.7 to 98.1 % remaining energy is discarded to the atmosphere or the like mainly as a heat loss, which is a lot of waste.

Further, for heat supply, the heat is generally supplied from a boiler fueled with oil or gas, and about 70 to 90% of input energy is supplied as heat energy such as steam and hot water and about 10 to 30% remaining energy becomes an energy loss.

From a viewpoint of energy saving for reducing such wastes, a method for effective use of energy has been actively grouped for since the oil crisis took place.

A conventionally adopted approach to effective use of energy is a system simultaneously supplying electricity and heat, which is made up of an internal combustion engine, turbine or the like fueled with city gas, petroleum, or the like, a power generator driven by rotary motive power of the internal combustion engine, turbine or the like, an exhaust gas boiler using high-temperature exhaust gas generated by the internal combustion engine, turbine or the like, and so on.

Besides, the development and practical application of an electricity/heat simultaneous supply system using a fuel cell are underway. The above electricity/heat simultaneous supply systems where the internal combustion engine, turbine or the like or the fuel cell is a core component (non-patent document 1) are described in detail in "Co-generation General Manual", Tsusan Shiryo Kenkyu Chosakai (Trade & Industry Material Research Committee), and so on.

"Combustion Type Light Emission Device and Manufacturing Method Therefor" of Japanese Patent Application Laid-open No. 2005-197243 describes that light from catalytic combustion is used as a light source and this light has a peak in a visible light component. However, without heat utilization and power generation, it is hard to say that energy is sufficiently and effectively utilized.

"Power Generation Equipment and Power Generation System Using Thermal-photovoltaic Power Generation" of Japanese Patent Application Laid-open No. 2002-354854 and "Thermal-photovoltaic Power Generation Device" of Kokoku (Japanese Examined Patent Publication) No. Hei 7-87251 describe power generation using heat and light of radiation from combustion or the like, and also describe a method of collecting heat of its exhaust gas. However, their main object is the power generation using combustion light, and they do not sufficiently describe that visible light components are split for illumination use from the combustion light.

In "Water Boiler" of Japanese Patent Application Laid-open No. 8-256915, combustion-type lighting fixtures for camping are combined, thereby enabling the supply of light and heat. However, no description is given of splitting combustion light into light in the visible spectrum and light in the heat ray spectrum and a means for utilizing heat has an open structure thus involves a great loss, which cannot be said as efficient.

"Catalytic Combustion Apparatus" of Japanese Patent No. 3071833 describes a method in which an apparatus for efficient catalytic combustion supplies only visible rays after removing heat rays, but gives no sufficient description of splitting combustion light into light in the visible spectrum and light in the heat ray spectrum, nor of a method of simultaneously supplying heat and electricity.

"Catalytic Combustion Apparatus" of Japanese Patent Application Laid-open No. Hei 10-141612 describes an apparatus for supplying heat and light by collecting illumination light and combustion heat from catalytic combustion. However, it is hard to say that the combustion light is efficiently split into light in the visible spectrum and light in the heat ray spectrum. Further, in order for the light of this apparatus to have directivity, some measure should be taken such as installing a reflector plate on an outer side of the apparatus, but an energy loss in the reflector plate is large and moreover no sufficient description is given of a method of supplying light by efficiently collecting light.

"Catalytic Combustion Apparatus" of Japanese Patent Application Laid-open No. Hei 11-211025 is an apparatus simultaneously supplying, from the same place, light and heat rays mainly for heating which are produced by catalytic combustion, and it is hard to say that combustion light is efficiently split into light in the visible spectrum and light in the heat ray spectrum and moreover it is hard to say that this apparatus is an illumination apparatus with high total energy efficiency. Another problem of this apparatus is an increase in cooling load for air-conditioning during a period, except winter, when heating is not required.

In "Thermal Photovoltaic Generation Method and Device Therefor" of Japanese Patent Application Laid-open No. 2000-106452, the power generation from combustion light by a photoelectric conversion element and the heat collection of heat of exhaust gas are simultaneously conducted. No sufficient description is given of the splitting of the combustion light into light in the visible spectrum and light in the heat ray spectrum in order to use the visible rays for illumination.

In "Heated Light-emitting Tube and Illumination Fixture and Heating System Using the Same" of Japanese Patent Application Laid-open No. 2003-51201, light, heat, and electricity are supplied from a vacuum tube by using light of a flame, but the light is generated by a light-emitting tube converting the heat, and the electricity is generated by a solar battery converting this light into electricity, and thus there occurs a large amount of loss at each stage of the energy conversion and it is hard to say that this method is efficient.

"Device for Gas Combustion" of Japanese Patent Application Laid-open No. 2005-49040 describes an illumination device in which visible rays are supplied from safe indoor gas combustion, but the problem is that indoor temperature is increased by many heat rays included in the light, and it is hard to say that this device is an illumination device with high total energy efficiency.

"Heater with Illumination" of Japanese Patent Application Laid-open No. 2002-303405 describes a device supplying both visible light and heat; however, since both visible light and heat are simultaneously supplied via a heat reflector plate or the like from the same place and the light includes heat rays, an increase in indoor temperature is a problem, and it is hard to say that this device is an illumination device with high total energy efficiency.

In "Gas Light" of Japanese Patent Application Laid-open No. 2002-932225, since light and combustion heat produced by gas combustion are supplied from the same place and the light includes heat rays, an increase in indoor temperature is a problem when this is used indoors, and it is hard to say that this gas light is an illumination device with high total energy efficiency.
Patent Document 1: Japanese Patent Application Laid-open No. 2005-197243 "Combustion Type Light Emission Device and Manufacturing Method Therefor"
Patent Document 2: Japanese Patent Application Laid-open No. 2002-354854 "Power Generation Equipment and Power Generation System Using Thermal-photovoltaic Power Generation"
Patent Document 3: Kokoku (Japanese Examined Patent Publication) No. Hei 7-87251 "Thermal-photovoltaic Power Generator"
Patent Document 4: Japanese Patent Application Laid-open No. 8-256915 "Water Boiler"
Patent Document 5: Japanese Patent No. 3071833 "Catalytic Combustion Apparatus"
Patent Document 6: Japanese Patent Application Laid-open No. Hei 10-141612 "Catalytic Combustion Apparatus"
Patent Document 7: Japanese Patent Application Laid-open No. Hei 11-211025 "Catalytic Combustion Apparatus"
Patent Document 8: Japanese Patent Application Laid-open No. 2000-106452 "Thermal Phtovoltaic Generation Method and Device Therefor"
Patent Document 9: Japanese Patent Application Laid-open No. 2003-51201 "Heated Light-emitting Tube and Illumination Fixture and Heating System Using the Same"
Patent Document 10: Japanese Patent Application Laid-open No. 2005-49040 "Device for Gas Combustion"
Patent Document 11: Japanese Patent Application Laid-open No. 2002-303405 "Heater with Illumination"
Patent Document 12: Japanese Patent Application Laid-open No. 2002-932225 "Gas Light"
Non-patent Document 1: "Co-generation General Manual", Tsusan Shiryo Kenkyu Chosakai (Trade & Industry Material Research Committee)

As seen from the above, in any of the aforesaid patent documents, it is difficult to realize high total energy efficiency of an illumination device that the illumination device according to the present invention described in the present specification can realize.

### Disclosure of the Invention

### Problems to be Solved by the Invention

However, in order to supply light by the aforesaid systems which simultaneously supply heat and electricity by using the internal combustion engine, turbine or the like, general practice is to supply fuel to the internal combustion engine, turbine or the like and supply light of illumination such as a fluorescent light and an incandescent light by using generated electricity. In the case of the internal combustion engine, turbine or the like, three times of energy conversion, that is, conversion from fuel to mechanical power, conversion from the mechanical power to electricity by the power generator, and conversion from the electricity to light, are required and an energy loss occurs at every energy conversion.

Here, even if exhaust heat generated from the internal combustion engine, turbine or the like is collected in amount equal to about 30% of the energy initially input to the internal combustion engine, turbine or the like, 60% or more of the initially input energy still becomes an energy loss.

Further, conventional illumination using a fluorescent light or an incandescent light radiates heat, whose amount is said to be as high as 80% or more of electric energy input for the illumination, and this heat radiation increases a cooling air-conditioning load in buildings where these illumination lights are installed, and therefore, how this load is reduced is a problem to be solved. At the same time, the reduction in cooling air-conditioning load is a task for solving a heat island phenomenon.

Further, since the internal combustion engine, turbine or the like involves the rotation, reciprocal movement, and the like of a machine, how to reduce big noise generated therefrom, which sometimes exceeds 110 dB (A), and vibration thereof is also a problem to be solved. This sometimes requires a special measure and thus an installation place of the internal combustion engine, turbine or the like is restricted.

Further, in the aforesaid system, many devices are installed; in a typical example, these devices are: an internal combustion engine, turbine or the like and a generator as major machines; a system for cooling these major machines; a heat collecting system such as an exhaust gas boiler collecting heat of exhaust gas; a cooling system for cooling combustion air and heat radiated from devices such as an internal combustion engine, turbine or the like main body; an air ventilation system; an electric board for controlling these devices; a sound insulating box and vibration isolating device for reducing noise and vibration; and when necessary, a denitrating device, a desulfurizing device, and the like as a system for purifying the exhaust gas; a tank storing fuel; and so on, and therefore, the installation space and the total weight of the system becomes a problem especially when the system is installed indoors.

Further, the aforesaid system using the fuel battery as its major component instead of the internal combustion engine, turbine or the like has a problem to be solved in view of that it often costs relatively high compared with the system using the internal combustion engine, turbine or the like and the life of the cell is short, and therefore, it is generally considered that such a system is still in the course of development and it takes time for the system to be put into practical use.

Further, due to the property of the fuel battery, the start-up from the cold state requires time, and therefore, the system is not generally suitable for the operation involving frequent repetition of start and stop and for the operation whose load constantly varies, though having no problem in the application in which the basic operation is continuous.

In view of the above tasks and problems of the conventional devices supplying visible rays from electric illumination by using electricity, it is an object of the present invention to realize effective use of energy and to provide a device which efficiently splits light generated by catalytic combustion to thereby simultaneously supply visible light, heat, and electricity, or visible light and heat, or visible light and electricity.

### Means for Solving the Problems

An illumination device according to the present invention can solve the problem of a large amount of energy loss that occurs in many other illumination devices, owing to its apparently higher total energy efficiency than that of the other illumination devices, as described below. The high total energy efficiency in the illumination device according to the present invention is realized by splitting the wavelength spectrum of combustion light into visible rays and heat rays for the efficient use of combustion light, by reducing radiation of the heat rays to an illuminated object, and so on.

There is provided a device including: a catalytic combustion part fueled with combustible gaseous substance such as city gas; a means efficiently splitting combustion light generated from the catalytic combustion part; and a thermoelectric element converting heat into electricity, thereby simultaneously supplying visible light and heat, or visible light, heat, and electricity, or visible light and electricity.

There is provided a device capable of simultaneously supplying light and heat, the device including: an air supply means 1; a gaseous fuel supply means 2; a combustion part 3; a reflector plate 4 provided around the combustion part 3; a translucent panel 5 installed in a part not surrounded by the reflector plate 4; a heat collecting means 7 installed in contact with whole or part of a rear surface of the reflector plate 4; and an exhaust gas discharge means 8, wherein the reflector plate 4 reflects a visible ray and transmits or absorbs a heat ray, is a heat-resistant surface which is made of a simple thin film of metal or metal oxide or is made of glass, ceramic, metal, or the like covered with the thin film or corting, and has the same function as that of a so-called cold mirror or dichroic mirror, that is, this illumination device is capable of simultaneously supplying light and heat, which includes: a combustion part; a reflector plate which is provided around the combustion part and which reflects a visible ray and transmits or absorbs a heat ray; a translucent panel installed in a part not surrounded by the reflector plate; a heat collecting means installed in contact with whole or part of a rear surface of the reflector plate; an exhaust gas discharge means connecting an installation space of the combustion part with an external part of the space and discharging exhaust gas generated in the combustion part to the external part of the space; an air supply means supplying air for combustion to the combustion part from the external part of the installation space of the combustion part; and a gaseous fuel supply means supplying a gaseous fuel for combustion to the combustion part.

Further, there is provided an illumination device capable of simultaneously supplying light, heat, and electricity, the device including: an air supply means 1; a gaseous fuel supply means 2; a combustion part 3; a reflector plate 4 provided around the combustion part 3; a translucent panel 5 installed in a part not surrounded by the reflector plate 4; a power generating element 6 installed in contact with whole or part of a rear surface of the reflector plate 4; a heat collecting means 7 provided on a rear surface of the power generating element 6; and an exhaust gas discharge means 8, that is, this is an illumination device capable of simultaneously supplying light, heat, and electricity, in which the power generating element is provided between the reflector plate and the heat collecting means in the above-described illumination device capable of simultaneously supplying light, heat, and electricity, with a front surface of the power generating element being in contact with whole or part of the reflector plate and with a rear surface of the power generating element being in contact with whole or part of the heat collecting means.

Further, there is provided an illumination device capable of simultaneously supplying light and electricity, the device including: an air supply means 1; a gaseous fuel supply means 2; a combustion part 3; a reflector plate 4 provided around the combustion part 3; a translucent panel 5 installed in a part not surrounded by the reflector plate 4; a power generating element 6 installed in contact with whole or part of a rear surface of the reflector plate 4; a cooling means 9 provided on a rear surface of the power generating element 6; and an exhaust gas discharge means 8, that is, this is an illumination device capable of simultaneously supplying light and electricity, which includes the cooling means installed in contact with whole or part of the rear surface of the power generating element to cool the rear surface of the power generating element, instead of the heat collecting means in the above-described illumination device capable of simultaneously supplying light and electricity.

Further, this illumination device is characterized in that the translucent panel 5 transmits a visible ray and reflects a heat ray; is a translucent surface made of a simple metal or metal oxide or made of glass, ceramic, resin, or the like covered with the thin film or corting; and has the same function as that of, for example, a cold filter, that is, the illumination device is characterized in that the translucent panel transmits a visible ray and reflects a heat ray.

Further, the illumination device is characterized in that the power generating element 6 is a thermoelectric element converting heat of combustion light into electricity.

### Effect of the Invention

In the illumination device according to the present invention, the number of times of the energy conversion for supplying visible rays is only once, which means a small loss by the energy conversion. Further, high-temperature heat rays with high energy are collected as electricity by thermoelectric conversion when necessary, and when the device is combined with an exhaust gas heat exchanger, uncollected heat can be collected as hot water or steam, which enables cascade use of energy and thus is efficient.

Further, not having a moving part which rotates or reciprocates, the illumination device is far quieter than an internal combustion engine, turbine or the like. Further, since light supplied from the illumination device according to the present invention is light which is obtained after light in the heat ray spectrum is filtered out, this light gives smaller influence of increasing indoor cooling air-conditioning load than conventional illumination such as a fluorescent light and an incandescent light.

The high energy efficiency attained by the illumination device according to the present invention is realized by splitting the light radiated from the combustion part into heat rays and visible rays by using the reflector plate and the translucent panel and by collecting and using the these rays so as to reduce their losses, which is made possible by providing the reflector plate around the combustion part and providing the heat collecting means in contact with whole or part of the rear surface of the reflector plate, in the case of the illumination device capable of simultaneously supplying light and heat, and the high total energy efficiency which is a feature of the illumination device according to the present invention cannot be realized only by simply combining these reflector plate, translucent panel, and heat collecting means so as to surround the combustion part. In the case of an illumination device capable of simultaneously supplying light, heat, and electricity and an illumination device capable of simultaneously supplying light and electricity, it is difficult to realize the high total energy efficiency, similarly to the above case, unless they have the structure described in the present specification.

The reason is that, as for the illumination device capable of simultaneously supplying light and heat according to the present invention, in order to "I. supply as many visible rays as possible with the least energy loss", as many visible components as possible in the combustion light radiated toward all directions from the combustion part need to be radiated to an illuminated object from the translucent panel, and for this purpose, the reflector plate and the translucent panel installed to surround the combustion part need to have as large areas as possible. On the other hand, in order to "II. supply as much heat as possible with the least energy loss", it is necessary to collect as many heat ray components as possible from the combustion light radiated in all the directions from the combustion part, and for this purpose, the heat collecting means installed to surround the combustion part need to have as large an area as possible. Here, the total surrounded area of the combustion part is determined to some degree by the size of the illumination device itself. Therefore, if the areas of the reflector plate and the translucent panel are increased, the area of the heat collecting means is accordingly decreased, and if conversely the area of the heat collecting means is increased, the areas of the reflector plate and the translucent panel are accordingly decreased, and thus the above I and II are contradictory to each other and therefore, even if the reflector plate, the translucent panel, and the heat collecting means are installed so as to simply surround the combustion part, it is difficult to satisfy both the above I and II.

Further, in order to "III. reduce the radiation of the heat rays to the illuminated object as much as possible", the heat rays radiated from the translucent panel need to be reduced as much as possible, and for this purpose, the illumination device according to the present invention has a feature that the reflector plate provided around the combustion part reflects visible rays and transmits or absorbs heat rays, and further, since the heat collecting means is installed in contact with whole or part of the rear surface of the reflector plate, the installation area of the heat collecting means can be as large as the total area surrounding the combustion part excluding the portion where the translucent panel is provided. Therefore, in the illumination device according to the present invention, the above I and II can be both satisfied.

Further, by increasing the area of the reflector plate, which has the property of transmitting or absorbing heat rays, as much as possible, it is possible to supply as many visible rays as possible and reduce the radiation of heat rays to the illuminated object as much as possible. That is, the heat rays included in the combustion light radiated toward the reflector plate from the combustion part are transmitted or absorbed by the reflector plate and thus their radiation to the illuminated object from the translucent panel is reduced. Therefore, since the illumination device according to the present invention can satisfy all the above I, II, and III, the illumination device according to the present invention can realize higher total energy efficiency than a device in which the reflector plate, the heat collecting means, and the translucent panel are simply combined.

In an illumination device capable of simultaneously supplying light, heat, and electricity in which the reflector plate, the heat collecting means, the translucent panel, and the power generating element are simply combined so as to surround the combustion part, in order to realize "IV. the power generation with the least energy loss" in addition to the above I, II, and III, the power generating element needs to have an increased heated area and needs to be installed around the combustion part so as to be capable or directly receiving the heat rays, that is, heat radiation, with less loss, so that it receives higher-temperature heat. It is further necessary to sufficiently cool a surface opposite a heated surface of the power generating element. Therefore, in the device in which the reflector plate, the heat collecting means, the translucent panel, and the power generating element are simply combined so as to surround the combustion part, the above I, II, and IV are contradictory to one another. That is, if the installation area of the power generating element is increased, the installation area of the other reflector panel, translucent panel, and heat collecting means becomes relatively small. On the other hand, if the installation area of the reflector plate, the translucent panel, and the heat collecting means is increased, the installation area of the power generating element becomes relatively small. Further, similarly to the above, since I and II, and I and III are contradictory to each other, it is difficult to satisfy all the above I, II, III, and IV in the device in which the reflector plate, the heat collecting means, the translucent panel, and the power generating element are simply combined so as to surround the combustion part.

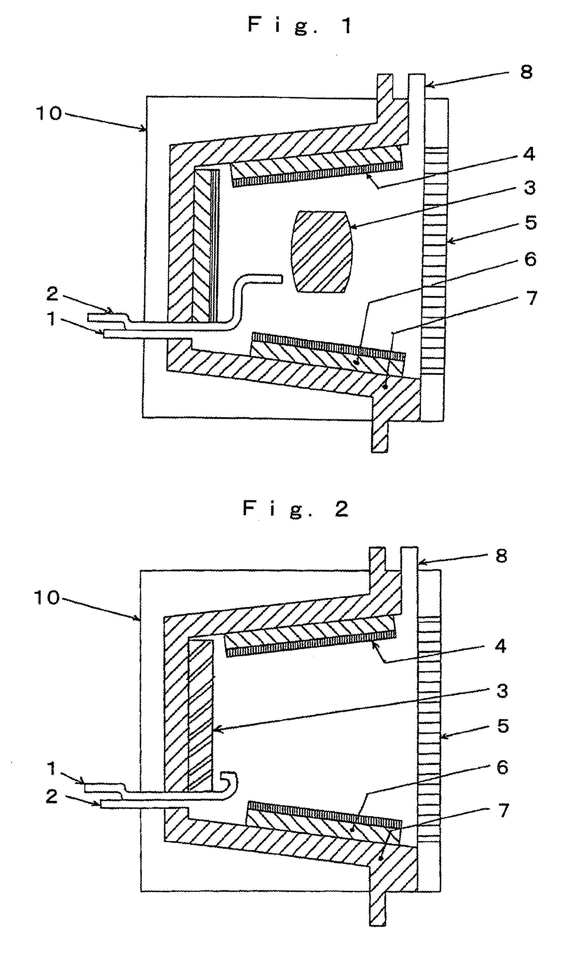

On the other hand, in the illumination device according to the present invention, the reflector plate provided around the combustion part has properties of reflecting visible rays and transmitting or absorbing heat rays, and the power generating element is installed between the reflector plate and the heat collecting means so as to be in contact with whole or part thereof as illustrated in Fig. 1. That is, the power generating element is installed in contact with whole or part of the rear surface of the reflector plate, and the heat collecting means is installed in contact with whole or part of the rear surface of the power generating element. Therefore, capable of satisfying all the above I, II, III, and IV, the illumination device according to the present invention can realize higher total energy efficiency than the device in which the reflector plate, the heat collecting means, the translucent panel, and the power generating element are simply combined so as to surround the combustion part.

In an illumination device capable of simultaneously supplying light and electricity, in which the reflector plate, the cooling means, the translucent panel, and the power generating element are simply combined so as to surround the combustion part, since the above I and III, and I and IV are contradictory to each other as described above, it is difficult to satisfy all the above I, III, and IV.

On the other hand, in the illumination device according to the present invention, the reflector plate provided around the combustion part has properties of reflecting visible rays and transmitting or absorbing heat rays, and the device has the cooling means which is provided in contact with whole or part of the rear surface of the power generating element to cool the rear surface of the power generating element, which makes it possible to satisfy all the above I, III, and IV, and therefore, the illumination device according to the present invention can realize higher total energy efficiency than the device in which the reflector plate, the cooling means, the translucent panel, and the power generating element are simply combined so as to surround the combustion part.

In the illumination device according to the present invention, the translucent panel has properties of transmitting visible rays and reflecting heat rays, and therefore, the illumination device according to the present invention has an effect of preventing the heat rays from being radiated to an illuminated object from the translucent panel, and the translucent panel reflects the heat rays out of wavelength components of combustion light radiated directly to the translucent panel from the combustion part and the reflector plate transmits or absorbs these heat rays, so that the heat rays can be effectively used, which makes it possible to further improve total energy efficiency of the illumination device according to the present invention.

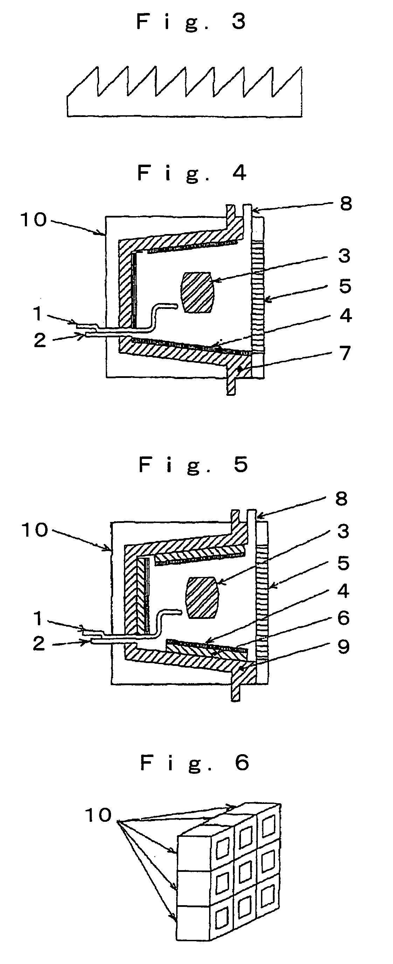

An illumination device system according to the present invention can form an illumination device unit in an arbitrary shape as in Fig. 6 by arbitrary combination of units each of which is the illumination device in Fig. 1. This makes it possible to easily decide the maximum output of the illumination device unit, and further to adjust light/heat/electricity outputs of the illumination device unit by turning on/off the individual illumination devices and by adjusting supply amounts of gaseous fuel to the individual illumination devices.

The illumination device system according to the present invention is simpler than a system simultaneously supplying heat and electricity by using an internal combustion engine, turbine or the like, and thus can be relatively compact and light-weighted.

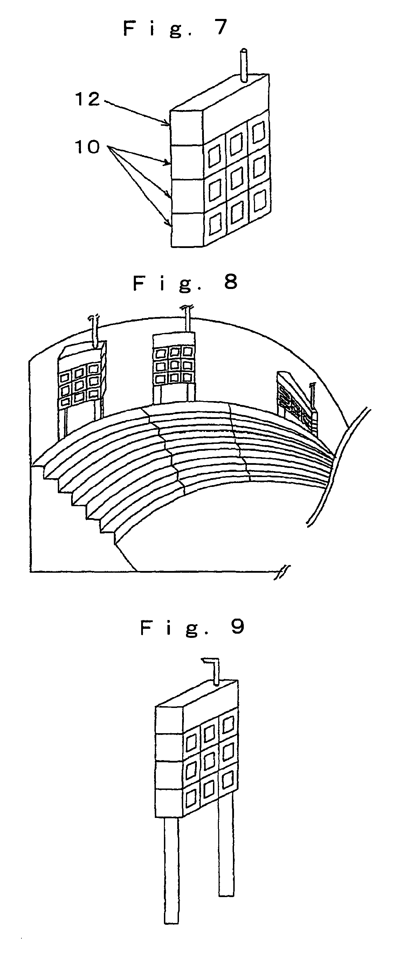

Further, by mounting an exhaust gas heat exchanger on the illumination device unit as shown in Fig. 7, for instance, it is possible to collect heat of high-temperature exhaust gas discharged from the exhaust gas discharge means 8 of the illumination devices, realizing higher total energy efficiency of the illumination device unit.

As for the system including the illumination device according to the present invention, maintenance as an illumination device is easy since the number of the combustion parts 3 generating light is smaller than that of a fluorescent light and an incandescent light installed in, for example, a building and this system is installed only in a limited place.

The illumination device system according to the present invention can be used as an illumination, a power source, and a heat source for emergency if storing liquid fuel or gaseous fuel in a tank or the like.

The illumination device system according to the present invention does not have a part such as an internal combustion engine, turbine or the like moving under a severe condition such as a high-temperature and high-pressure condition, and can be formed by the combination of the plural units, and therefore its reliability as a facility can be easily made relatively high.

Further, in the illumination device system according to the present invention, the high total energy efficiency is concretely realized by the effective use of visible rays and heat rays, which is attained by splitting light in the wavelength spectrum of combustion light into visible rays and heat rays, and by the small heat release to the illuminated object. In order to realize this, the reflector plate provided around the combustion part reflects visible rays and transmits or absorbs heat rays. Light as illumination is radiated from the translucent panel. Based on these, by providing the heat collecting means in contact with whole or part of the rear surface of the reflector plate, it is possible to form the illumination device which is capable of simultaneously supplying light and heat, and by providing the power generating element between the reflector plate and the heat collecting means, with the front surface of the power generating element being in contact with whole or part of the reflector plate and the rear surface of the power generating element being in contact with whole or part of the heat collecting means, it is possible to form the illumination device capable of simultaneously supplying light, heat, and electricity, and further, by providing, instead of the heat collecting means, the cooling means which is installed in contact with whole or part of the rear surface of the power generating element to cool the rear surface of the power generating element, it is possible to form the illumination device capable of simultaneously supplying light and electricity.

Further, since the translucent panel has properties of transmitting visible rays and reflecting heat rays, heat release to the illuminated object is reduced, so that total energy efficiency of the illumination device can be further improved.

### Brief Description of Drawings

Fig. 1 is a cross-sectional view of an illumination device capable of simultaneously supplying light, heat, and electricity;
Fig. 2 is a cross-sectional view of an illumination device whose combustion part is installed in an end portion;
Fig. 3 is a reflector plate with a rugged structure, provided in the illumination device;
Fig. 4 is a cross-sectional view of an illumination device capable of simultaneously supplying light and heat;
Fig. 5 is a cross-sectional view of an illumination device capable of simultaneously supplying light and electricity;
Fig. 6 is an example of an illumination device unit where the illumination devices are combined in three vertical tiers and three horizontal rows;
Fig. 7 is an example of an illumination device unit on which an exhaust gas heat exchanger is mounted;
Fig. 8 is an example where the illumination device is applied in an indoor athletic stadium;
Fig. 9 is an example of an illumination device unit with an exhaust gas heat exchanger having support legs;
Fig. 10 is a view of the system flow in the example where the illumination device device is applied in the indoor athletic stadium;
Fig. 11 is an illumination device for a building or the like as an example of a system sending light supplied from the illumination device to a distant place;
Fig. 12 is an example of a system where the illumination device is applied in a building or the like;
Fig. 13 is an illumination device unit for a building or the like in which the illumination devices for a building or the like and the exhaust gas heat exchanger are combined;
Fig. 14 is a view of the system flow in the example where the illumination device is applied in a building or the like; and
Fig. 15 is an example where a translucent panel of the illumination device has a polarization function.

### Best Mode for Carrying out the Invention

Hereinafter, embodiments of the present invention will be described with reference to the drawings.

Fig. 1 is a cross-sectional view of an illumination device according to the present invention. This is an illumination device capable of simultaneously supplying light, heat, and electricity, which includes an air supply means 1, a gaseous fuel supply means 2, a combustion part 3, a reflector plate 4 provided around the combustion part 3, a translucent panel 5 installed in a part not surrounded by the reflector plate 4, a power generating element 6 installed in contact with whole or part of a rear surface of the reflector plate 4, a heat collecting means 7 provided on a rear surface of the power generating element 6, and an exhaust gas discharge means 8. An exterior cover of the illumination device will be called a case 10.

Fig. 4 is a cross-sectional view of an illumination device according to the present invention. This is an illumination device capable of simultaneously supplying light and heat, which includes an air supply means 1, a gaseous fuel supply means 2, a combustion part 3, a reflector plate 4 provided around the combustion part 3, a translucent panel 5 installed in a part not surrounded by the reflector plate 4, a heat collecting means 7 installed in contact with whole or part of a rear surface of the reflector plate 4, and an exhaust gas discharge means 8. An exterior cover of the illumination device will be called a case 10.

Fig. 5 is a cross-sectional view of an illumination device according to the present invention. This is an illumination device capable of simultaneously supplying light and electricity, which includes an air supply means 1, a gaseous fuel supply means 2, a combustion part 3, a reflector plate 4 provided around the combustion part 3, a translucent panel 5 installed in a part not surrounded by the reflector plate 4, a power generating element 6 installed in contact with whole or part of a rear surface of the reflector plate 4, and an exhaust gas discharge means 8. A cooling means 9 is provided on a rear surface of the power generating element when necessary. An exterior cover of the illumination device will be called a case 10.

Each of the illumination devices in Fig. 1, Fig. 4, and Fig. 5 is characterized in that the reflector plate 4 reflects visible rays and transmits or absorbs heat rays. Further, the reflector plate 4 is a heat-resistant plane made of a simple thin film of metal or metal oxide, or made of glass ceramic, metal, or the like covered with the thin film or corting, and can be a cold mirror or a dichroic mirror, for instance.

Each of the illumination devices in Fig. 1, Fig. 4, and Fig. 5 is
characterized in that the translucent panel 5 transmits visible rays and reflects heat rays. Further, the translucent panel 5 is a translucent plane made of simple metal or metal oxide or made of glass, ceramic, resin, or the like covered with the thin film or corting, and can be a cold filter, for instance.

Each of the illumination devices in Fig. 1 and Fig. 5 is characterized in that the power generating element 6 is a thermoelectric element converting heat of the combustion light into electricity.

The reflector plate can be a continuous plane or a single or a plurality of partly lacking planes and has a substantially cup shape surrounding the combustion part, and this plane can be made of the combination of curved surfaces or planar surfaces, but is preferably a continuous plane in view of heat receiving efficiency. Further, in order to improve reflection efficiency of the combustion light by the reflector plate to the translucent panel which is provided as illustrated in Fig. 1, Fig. 4, and Fig. 5 on a surface corresponding to a cup front surface, that is, on a surface where the reflector plate in the substantially cup shape is not provided, the reflector plate is preferably installed at such an angle to reflect the combustion light toward the translucent panel. Further, the reflector plate may have a rugged structure as in Fig. 3, for instance.

The air supply means 1 supplies air for combustion to the combustion part 3. Further, it cools an installation space of the combustion part 3, the reflector plate 4, or the translucent panel 5 when necessary. Further, the air supply means 1 supplies the air for combustion to the combustion part from an external part of the installation space of the combustion part, and may be an opening via which the outside air and the combustion part 3 communicate with each other, or may be a duct or a pipe through which the outside air and the combustion part 3 communicate with each other. Further, the air supply means 1 may be provided at one place or at a plurality of places.

Further, in the air supply means 1, at one of an upstream position, a middle position, and a downstream position of the aforesaid opening, duct, or pipe, a regulating means is installed to regulate necessary ones out of flow rate, pressure, temperature, and humidity of air, an air excess ratio in the combustion part 3, and so on as required. Here, the regulating means is a fan, a compressor, a valve, an orifice, a heat exchanger, or the like. As the fan, one of a propeller fan, a sirocco fan, a turbo fan, a mixed flow fan, a rotary fan, and the like is selected as required.

As the compressor, one of a reciprocating compressor, a rotary compressor, a turbo compressor, a screw compressor, a vibrating compressor, and the like is selected as required. The number of the fans or the compressors is decided as required, and in order to regulate an air volume of the fan, the number of rotations may be switchable in stages, or the control of the number of rotations using an inverter may be adopted.

Among these examples, a fan and a valve are preferably used as the air regulating means because they can provide many options of the air volume from a small air volume to a large air volume, and they cost low if a blowing pressure may be about 100 mm Aq. As the fan, a propeller fan (axial fan) is desirable because it can provide many options of the air volume, from a small air volume to a large air volume, and it costs low if a blowing pressure may be about 100 mm Aq. The fan is preferably provided in the middle position of the duct forming the air supply means.

Next, the valve can be a butterfly valve, a globe valve, a gate valve, an angle valve, a needle valve, a pressure regulating valve, a flow rate regulating valve, an opening/closing damper, or the like. A required number of manual valves or automatic valves operated by electricity, compressed air, or the like are provided as required. As the automatic valve, a self-controlled valve or a valve controlled by an external signal or the like is used as required. The orifice may be of a single-tire type or may be of a multi-tier type. As the heat exchanger, a shell-and-tube type, a fin-tube type, a plate type, or the like is selected as required.

The air supply means is a duct, for instance, with its one end being an air admission port in contact with the outside air, and with the axial fan being provided in the middle between the air admission port and the case, and passes through the case, with its other end communicating with the installation space of the combustion part.

The aforesaid air is for causing a combustion reaction with the gaseous fuel and may be atmospheric air or indoor air, or may be oxygen or oxygen-containing gas, other than air. Alternatively, it may be gas other than oxygen, causing a combustion reaction with the gaseous fuel.

The gaseous fuel supply means 2 is used to supply the combustion part 3 with the gaseous fuel for combustion. This gaseous fuel supply means 2 is a duct or a pipe coupled to a gaseous fuel supply pipe and a tank provided in an external part of the illumination device, and at an upstream position, a middle position, or a downstream position of the duct or the pipe, a regulating means for regulating a flow rate, pressure, temperature, and humidity of the gaseous fuel and an air excess ratio in the combustion part 3 is provided as required.

Further, the regulating means in the gaseous fuel supply means is a fan, a compressor, a valve, an orifice, or a heat exchanger, and as the fan, a propeller fan, a sirocco fan, a turbo fan, a mixed flow fan, a rotary fan, or the like is selected as required.

As the compressor, a reciprocating compressor, a rotary compressor, a turbo compressor, a screw compressor, a vibrating compressor, or the like is selected as required. The number of the fans or the compressors is decided as required, and the number of rotations of the fan may be switchable in stages or the control of the number of rotations using a frequency control inverter may be adopted.

Next, the valve can be a butterfly valve, a globe valve, a gate valve, an angle valve, a needle valve, a pressure regulating valve, a flow rate regulating valve, or the like. A required number of manual valves or automatic valves operated by electricity, compressed air, or the like are provided as required. As the automatic valve, a self-controlled valve or a valve controlled by an external signal or the like is used as required. The orifice may be of a single-tire type or may be of a multi-tier type. As the heat exchanger, a shell-and-tube type, a fm-tube type, a plate type, or the like is selected as required.

If city gas, which is one of gaseous fuels, generally has a 0.1 to 0.8 MPa pressure and is supplied at an intermediate pressure, is used, a self-controlled pressure reducing valve among these examples is preferable in view of supplying the gaseous fuel at an appropriate pressure to the combustion part, and as the regulating means for enabling the gaseous fuel to be supplied to the combustion part at a necessary flow rate, the flow rate regulating valve arbitrarily regulatable by an external control signal is preferably provided.

A preferable example of the gaseous fuel supply means 2 in terms of appropriately supplying the gaseous fuel to the combustion part is a city gas pipe, and its one end is coupled to a gas pipe of a gas company and the other end is led to a position very close to the combustion part. Further, the air supply means 1 may be provided at one place or may be provided at a plurality of places.

The gaseous fuel supply means 2 has: a manual master valve, which is provided at a position before the gaseous fuel supply means 2 extending from the pipe of the gas company reaches the case and which starts/stops the gas supply; and a shut-off valve of an electromagnetic type or the like which is provided on a downstream side of the master valve and is automatically openable/closable; a self-controlled pressure reducing valve on a further downstream side; and the automatic flow rate regulating valve provided on a further downstream side, and the gaseous fuel supply means 2 then passes through the case, with the other end being led to the position close to the combustion part 3.

Further, near the end of the gas pipe led to the position close to the combustion part 3, an ignition device for igniting the gaseous fuel is provided when necessary. The ignition device may of a type generating sparks by electricity or the like, or may be of a type having the same function as a device for home use such as a household cooking stove.

The gaseous fuel may be a combustible gaseous substance such as city gas, methane gas, propane gas, hydrogen gas, or a substance resulting from the gasification of a combustible liquid substance such as kerosene, heavy fuel oil, or gasoline originating from petroleum, or may be a substance resulting from the gasification of a combustible solid substance such as methane hydrate.

Further, instead of the air supply means 1 and the gaseous fuel supply means 2, a mixed gas supply means where the air and the gaseous fuel to the combustion part 3 are suitably mixed by a mixer may be installed, and the supply method of mixed gas of the air and the gaseous fuel by the mixed gas supply means to the combustion part 3 may be the same as that by the gaseous supply means. To suitably mix means the state where the air and the gaseous fuel are mixed substantially uniformly by the mixer. When necessary, an air-fuel ratio is regulated.

The combustion part 3 is a part which bums the mixed gas of the air and the gaseous fuel supplied by the air supply means 1 and the gaseous fuel supply means 2 or by the mixed gas supply means, thereby generating combustion light. The combustion part 3 is entirely or partly formed by a catalyst, and it is structured in a string form, a spiral form, a net form, or the like, or has a honeycomb structure, a porous structure, or the like. The catalyst forming the combustion part 3 is formed in a flat plane shape, a curved plane shape, a linear shape, a circular cylindrical shape, a polygonal prismatic shape, a cubic shape, a rectangular parallelepiped shape, a spherical shape, or the like, and when necessary, it has sometimes a hollow structure.

Among these examples, the combustion part 3 is preferably in a net form and has a hollow substantially spherical shape in view of high-brightness combustion.

Further, the combustion part 3 may be installed substantially in the center as shown in Fig. 1, or may be installed as shown in Fig. 2 or at a position other than the position shown in Fig. 2, and catalytic combustion which can be high-brightness combustion is realized there. Further, the number of the combustion parts 3 may be one or may be plural when necessary.

As a material of the combustion part 3, used is an inorganic substance such as metal, ceramic, or glass, a carbide of mantle (soaked with or coated with light-emitting material such as sodium nitrate or a fluorescent material), or the like. Among these examples, mantle is preferable in view of efficient high-brightness combustion, and metal and ceramic are preferable in view of long life.

The reflector plate provided around the combustion part 3 reflects light in the spectrum including visible rays of the combustion light emitted from the combustion part 3 and transmits or absorbs light in the spectrum including heat rays.

Providing the reflector plate around the combustion part means that the reflector plate has a substantially cup shape surrounding upper/lower and right/left sides of the combustion part. The substantially cup shape surrounding the combustion part may mean that the reflector plate is composed of a single surface or a plurality of surfaces and has a substantially cup shape surrounding the combustion part, and this shape may be a parabolic antenna shape, a saucer shape, a semispherical shape, a cone shape, or a pyramid shape, a polygonal shape composed of the combination of planar surfaces and curved surfaces, a circular cylindrical shape, a polygonal prismatic shape, a polygonal pyramid shape, or the like. Further, when necessary, there may be some part with no reflector plate and no translucent panel, that is, the reflector plate may have a partly lacking substantially cup shape.

Among these examples, in view of efficient reflection of the combustion light by the reflector plate, it is preferable that the reflector plate is installed to surround the combustion part without any break, and the shape of the reflector plate is decided so that the combustion light entering every point on the reflector panel at every incident angle is reflected as reflection light toward the translucent panel, in order for the reflector plate to have a shape reflecting as many wavelength components as possible in the visible spectrum out of all the wavelength components of the combustion light toward the translucent panel.

The reflector plate 4 is a heat-resistant plane made of simple metal or metal oxide or made of glass, ceramic, metal, or the like whose surface is covered with the thin film or corting, and has the same function as that of a so-called cold mirror or dichroic mirror. Further, the surface of the reflector plate 4 may be provided with a light-emitting element or may be coated with a light-emitting material or a fluorescent material. As the light-emitting material, a semiconductor, silicon, fluorocarbon resin, or the like, for instance, may be used.

In view of high heat collection efficiency and cooling efficiency on the rear surface of the reflector plate 4, the surface of the power generating element, the heat collecting means, or the cooling means is preferably a thin film coated with a thin film or corting of metal or metal oxide.

Further, the surface of the reflector plate 4 may be flat or curved in order to obtain an arbitrary reflection property, or sometimes has a rugged surface as shown in Fig. 3, for instance. Further, a part that reflects rays in the heat ray spectrum toward the combustion part may be provided for the purpose of assisting the catalytic combustion when necessary.

The rugged shape may be formed by straight lines, may be formed by curved lines, or may be formed by both straight lines and curved lines.

Further, the reflector plate 4 may have a function of a plane lens or a curved lens in order to concentrate heat that it transmits to its rear surface or rays that it reflects.

The translucent panel 5 transmits visible rays and reflects heat rays. It is a translucent single layer made of simple metal or metal oxide or made of glass, ceramic, resin, or the like whose surface is covered with any of these thin films or corting, or it is made up of a plurality of surfaces between which liquid or gas is inserted for the purpose of cooling, heat insulation, and heat collection, and has the same function as that of a so-called cold filter. Out of all the wavelength components of the combustion light generated from the combustion part, the wavelength components in the heat ray spectrum are reflected by the translucent panel, but the wavelength components in the visible spectrum pass through the translucent panel to be supplied to the external part, and at the same time, the visible components reflected by the reflector plate pass through the translucent panel to be supplied to the external part.

If the translucent panel is made up of the plural surfaces and liquid or gas is inserted there between for the purpose of cooling, heat insulation, and heat collection, air or the like is used as the gas, and water or the like is used as the liquid, and the gas, water, or the like is circulated between the translucent panel and the external part of the illumination device by a fan or a pump.

Further, the translucent panel may have a function of a plane lens or a curved lens in order to concentrate rays that it transmits and reflects.

The power generating element 6 converts heat and light of heat rays into electricity and is installed in contact with whole or part of the rear surface of the reflector plate, and the heat collecting means is provided on the rear surface of the power generating element. For example, the power generating element 6 is a thermoelectric element utilizing the Seebeck effect or a photoelectric element. As the thermoelectric element, either of a P-type and N-type semiconductors may be used, a stack of two or more different kinds of metals may be used, or other may be used. Further, the thermoelectric element has a single layer structure or a multilayer structure as required.

In view of efficiently taking out electricity, a preferable structure, among these examples, is such that semiconductors are used as heat transfer elements, and P-type semiconductors and N-type semiconductors are two-dimensionally and alternately arranged and conductive plates of metal or the like sandwich a top surface and a bottom surface.

The heat collecting means 7 is installed in contact with whole or part of the rear surface of the power generating element 6 or the reflector plate 4 to cool the power generating element 6 or the reflector plate 4 or to collect heat. For the cooling and the heat collection, liquid such as water or gas such as air is circulated by a pump, a fan, or the like from the inside of the illumination device to the external part; while being in contact with the rear surface of the power generating element 6 or the reflector plate 4, whereby collected heat is supplied or cooled. For efficient heat reception, the order of the circulation is preferably such that the liquid or the gas flows from a lower part toward an upper part of the illumination device as shown in Fig. 1, for instance.

The cooling means is installed in contact with whole or part of the rear surface of the power generating element 6 to cool the power generating element 6. For the cooling, liquid such as water or gas such as air is circulated by a pump, a fan, or the like from the inside of the illumination device to the external part while being in contact with the rear surface of the power generating element 6, whereby collected heat is supplied or cooled. For efficient heat reception, the order of the circulation is preferably such that the liquid or the gas flows from a lower part toward an upper part of the illumination device as shown in Fig. 1, for instance.

For enhanced heat transfer efficiency, the heat collecting means and the cooling means may have a return channel structure as that of a plate-type heat exchanger, for instance.

The exhaust gas discharge means 8 discharges high-temperature exhaust gas which has been burnt in the combustion part 3. The exhaust gas discharge means 8 may be provided at one place or a plurality of places. The exhaust gas supply means is an exhaust gas discharge means which connects the installation space of the combustion part and the external part of the space to discharge the combustion exhaust gas generated in the combustion part to the external part of the space. The exhaust gas discharge means 8 is provided with a fan for assisting the discharge of the exhaust gas when necessary. The fan may be installed at a position of an exit of the illumination device or at a position of an exhaust gas duct provided at an exhaust gas discharge port of the illumination device, or the fan may be installed in the pipe. Heat that the high-temperature exhaust gas has can be collected by a separately provided exhaust gas heat exchanger or the like when necessary and heat can be also supplied as steam and hot water from there.

The exhaust gas discharge means 8 is a pipe, for instance, with its one end connected to the installation space of the combustion part 3 in the case 10, and passes through the case to be led to the external part of the case. From there, it is led toward the downstream side to the exhaust gas heat exchanger 12 so that the heat of the high-temperature exhaust gas is collected when necessary. Further, when required, a fan for forcibly discharging the exhaust gas is provided on a further downstream side, and the exhaust gas discharge means 8 is finally led from an exit of the fan to the outdoor atmosphere so that the exhaust gas is emitted out.

It is preferable that a temperature sensor, for instance, as a detecting means for detecting that the gaseous fuel is being burnt is provided near the combustion part 3 in order to prevent a danger such as flue explosion which may occur if the unburnt gaseous fuel is erroneously discharged from the exhaust gas discharge means 8 while the gaseous fuel is burnt in the combustion part when the gaseous fuel is supplied, that is, when the master valve and the shut-off valve of the gas supply means are both opened.

Fig. 6 is an illumination device unit in which an arbitrary number of the illumination devices shown in Fig. 1 are, for example, two-dimensionally combined into a unit in order to realize a device supplying necessary illumination intensity. In combining the illumination devices into a unit, they may be combined so as to form a pseudo curved surface when required. Visible rays are supplied from a front surface of this unit.

Fig. 7 is an example of an illumination device with an exhaust gas heat exchanger in which the illumination device unit shown in Fig. 6 and an exhaust gas heat exchanger are combined and which has an exhaust gas stack. The mounting position of the exhaust gas heat exchanger may be a rear surface, a side surface, or the like of the illumination device unit, or may be a place apart from the illumination device unit as required. This unit is applied when heat of the high-temperature exhaust gas generated from the combustion part 3 is collected.

Hereinafter, the above-described contents regarding the operation of the illumination device will be briefly described by using the drawings as an example.

In Fig. 1, the gaseous fuel for combustion is supplied by the gaseous fuel supply means 1 to the combustion part 3 which is the catalyst, and at the same time, the air for combustion is supplied by the air supply means 2. In the combustion part 3, the gaseous fuel and air supplied as above cause catalytic combustion which has generally higher brightness than flame combustion.

The combustion light is generated from the catalytic combustion in the combustion part 3. The combustion light includes rays in a wide wavelength spectrum including heat rays and visible rays, ranging from the ultraviolet spectrum to the infrared spectrum. The combustion light is radiated from the combustion part 3 to be radiated toward the reflector plate 4 installed to surround the combustion part 3 and toward the translucent panel 5.

As for the combustion light radiated to the reflector plate 4, the reflector plate 4 reflects visible rays and transmits or absorbs heat rays, out of the wavelength components included in the combustion light. The visible rays reflected by the reflector plate 4 are radiated toward the translucent panel 5 directly or after repeating the re-reflection by the reflector plate 4 and so on, and pass through the translucent panel 5 to be supplied as illumination light to the external part of the illumination device.

Heat of the heat rays transmitted or absorbed by the reflector plate 4 is transferred to the power generating element 6 installed in contact with the rear surface of the reflector plate 4.

Meanwhile, as for the combustion light radiated toward the translucent panel 5 from the combustion part 3, out of the wavelength components included in the combustion light, the visible rays pass through the translucent panel 5 to be supplied as illumination light to the external part of the illumination device.

Further, out of the wavelength components included in the combustion light radiated to the translucent panel 5, the heat rays are reflected by the translucent panel 5. The heat rays reflected by the translucent panel 5 are radiated to the reflector plate 4 directly or after repeating the re-reflection by the translucent panel 5 and so on, and are transmitted or absorbed by the reflector plate 4 and heat thereof is transferred to the power generating element 6 installed in contact with the rear surface of the reflector plate 4.

If the power generating element 6 is, for example, a thermoelectric element converting heat into electricity, the thermoelectric element's surface in contact with the reflector plate 4 is heated by the heat transferred from the reflector plate 4, and the rear surface of the thermoelectric element is cooled by the heat collecting means 7 installed in contact with the rear surface of the thermoelectric element.

The heat collecting means 7 is made up of, for example, a heat exchanger using water as a medium, and it collects heat by cooling the rear surface of the thermoelectric element by the water supplied from an inlet provided in a lower part of the illumination device, and the water is discharged as heated water from an outlet provided in an upper part of the illumination device.

The exhaust gas generated in the combustion part 3 is discharged from the exhaust gas discharge means provided in the upper part of the illumination device.

As for the illumination device illustrated in Fig. 2 or Fig. 3, in Fig. 2, the power generating element 6 is not installed and a cooling means device 9 is installed instead of the heat collecting means 7, in contact with the rear surface of the reflector plate 4 similarly to the heat collecting means 7. Further, in Fig. 3, a cooling means 9 is installed similarly to the heat collecting means 7 instead of the heat collecting means 7.

As an application example of a system using the illumination device according to the present invention, the system is applicable in an indoor athletic stadium, hall, and so on as shown in Fig. 8, for instance. The illumination device units with the exhaust gas heat exchanger shown in Fig. 7 are installed at required places of the indoor athletic stadium or the like to supply visible rays necessary in the indoor athletic stadium or the like. As an installation method of this unit, this unit may be formed to have support legs which are provided upright on a floor to support this unit as shown in Fig. 9, or may be suspended from a ceiling, or may be supported on a wall, a ceiling surface, or the like. Further, instead of the illumination unit with the exhaust gas heat exchanger shown in Fig. 7, the illumination device unit shown in Fig. 6 may be provided.

From the translucent panel 5, visible rays are supplied as the illumination for the interior of the athletic stadium. Further, collected heat is supplied as hot water or steam when necessary by the combination of the heat collecting means 7 and the exhaust gas heat exchanger. Possible examples of the use of the collected heat may be the use as a heat source or the like of an indoor air-conditioning facility, the use for the purpose of hot-water supply, and the like. Possible examples of the air-conditioning facility are a hot water or steam absorption chiller and the like. Alternatively, the heat may be supplied to a hot water system or the like such as a district heat supply system which is widely installed especially in Europe.

Further, if the power generating element 6 is provided in the aforesaid application example, electricity generated by the power generating element may be used as motive power of auxiliary machinery and equipment forming the system to which the illumination device is applied, may be used as a power load of an athletic stadium or the like, or may be sold to a grid of an electric power company.

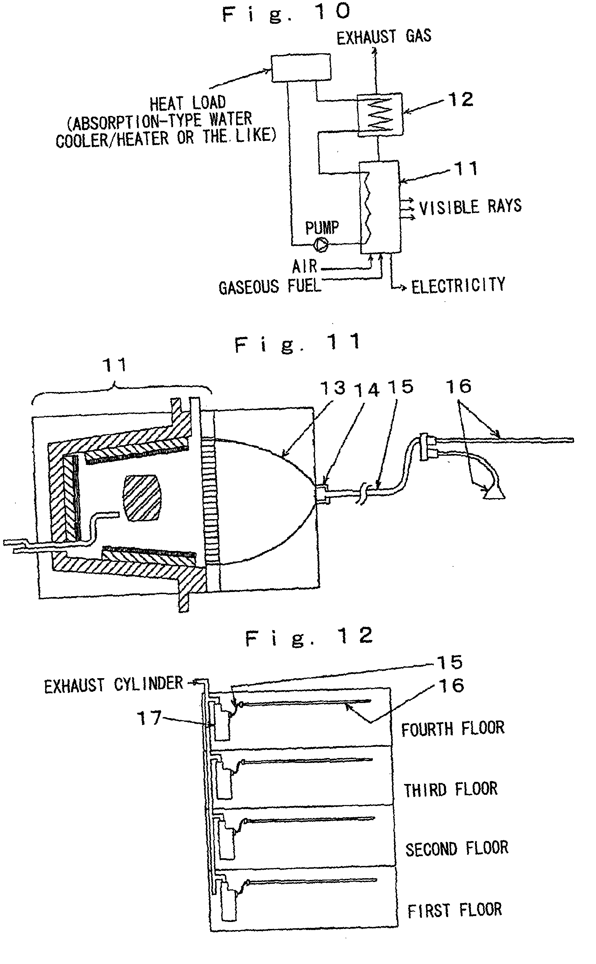

Fig. 10 shows an example of a view of the system flow in the aforesaid example where the illumination device is applied in the indoor athletic stadium. City gas as the gaseous fuel together with air is supplied to the illumination device unit, and visible rays are supplied from the translucent panels on the front surface of the illumination device unit. Water, after supplied to the heat collecting means of the illumination device, is further supplied to the exhaust gas heat exchanger, so that hot water with increased temperature is supplied as a heat source to a hot water type absorption chiller or the like which is an end user of the heat. The water with reduced temperature after used in the hot water absorption chiller or the like is supplied again to the illumination device, and its heat is collected. A pump or the like is used to circulate the water.

Next, as an example of a system supplying the light, which is supplied from the illumination device according to the present invention, to a place distant from an installation place of the illumination device, a system shown in Fig. 11 is possible. The light supplied from the translucent panel 5 is collected to a light-collecting part 14 by a light-collecting plate 13 surrounding the translucent panel 5, and the collected light is sent to a desired place through a light transmission pipe 15 to be supplied from a light-emitting part 16.

Here, as the light transmission pipe 15, a glass fiber with high light transfer efficiency may be used, for instance. Further, as the light-emitting part 16, usable is a glass fiber whose outer peripheral surface and end surface emit light.

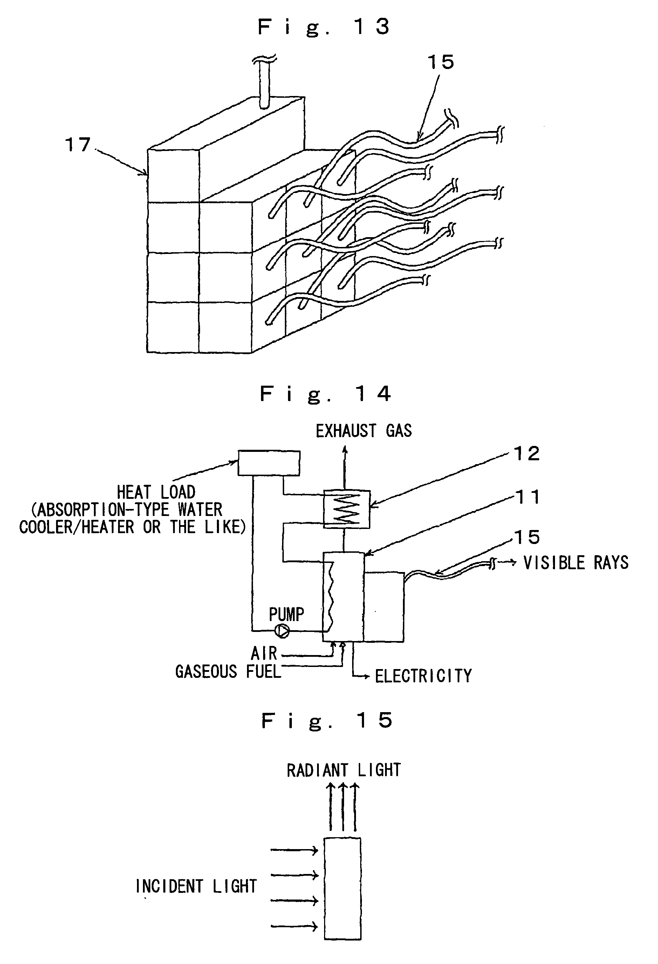

Further, the number of the light transmission pipes 15 and the light-emitting parts 16 may be one or plural per one illumination device 1. Further, the translucent panel 5 may serve also as the light collecting plate 13. Further, the translucent panel 5 may have a polarization function as shown in Fig. 15, for instance, thereby allowing arbitrary setting of the position of an exit of light. In this case, the light collecting plate or the light collecting part is provided at the exit of light.

As another application example of the illumination device system according to the present invention, the system is applicable in a building or the like as shown in Fig. 12, for instance. Possible application examples other than the application in a building are applications in a department store, a shopping center, a hospital, a school, a factory, an underground mall, a station, an airport, an indoor pool, a public bathhouse, and so on. The application in a multiple dwelling house such as an apartment house and the application in a stand-alone house are also possible.

If the systems shown in Fig. 11 for supplying light, which is supplied from the illumination device according to the present invention, to a place distant from the installation place of the illumination device are installed at substantially the same positions of respective floors of a building or the like as shown in Fig. 12, the distance of a fuel gas system, an exhaust gas system, a heat collecting or supplying system, and the like can be made short, which is economical.

Fig. 14 shows an example of a view of the system flow in the example where the illumination device is applied in a building or the like as shown in Fig. 12.

Another possible application example is to safely supply light to a dangerous area such as an explosion-proof area which involves a danger of explosion and the like due to fire, sparks, and the like. Further, if the gaseous fuel is stored in a tank or the like, the application as the illumination for emergency is also possible

### Industrial Applicability

The present invention relates to a device capable of simultaneously supplying visible light, heat, and electricity, or visible light and heat, or visible light and electricity, from catalytic combustion fueled with combustible gaseous fuel such as city gas.

## Claims

1. An illumination device comprising:
a combustion part;
a reflector plate provided around said combustion part to reflect a visible ray and transmit or absorb a heat ray;
a translucent panel installed in a part not surrounded by said reflector plate;
a heat collecting means installed in contact with whole or part of a rear surface of said reflector plate;
an exhaust gas discharge means coupling an installation space of said combustion part and an external part of the space and discharging exhaust gas generated in said combustion part to the external part of the space;
an air supply means supplying air for combustion to said combustion part from the external part of the installation space of said combustion part; and
a gaseous fuel supply means supplying gaseous fuel for combustion to said combustion part, and
the device being capable of simultaneously supplying light and heat.

2. The illumination device according to claim 1, further comprising
a power generating element provided between said reflector plate and said heat collecting means in claim 1, with a front surface of said power generating element being in contact with whole or part of said reflector plate, and a rear surface of said power generating element being in contact with whole or part of said heat collecting means, and
the device being capable of simultaneously supplying light, heat, and electricity.

3. The illumination device according to claim 2, further comprising, instead of said heat collecting means in claim 2, a cooling means which is provided in contact with whole or part of the rear surface of said power generating element to cool the rear surface of the power generating element, and
the device being capable of simultaneously supplying light and electricity.

4. The illumination device according to claims 1, 2, and 3, wherein said translucent panel in claims 1, 2, and 3 transmits the visible ray and reflects the heat ray.

5. The illumination device according to claims 2 and 3, wherein said power generating element in claims 2 and 3 is a thermoelectric element converting heat of combustion light generated by said combustion part into electricity.
